Europäisches Patentamt

European Patent Office

Office européen des brevets

(19)

(11) **EP 0 479 109 B1**

(12) **EUROPEAN PATENT SPECIFICATION**

(45) Date of publication and mention
of the grant of the patent:
**18.09.1996 Bulletin 1996/38**

(51) Int Cl.6: **G11B 11/10**, G11B 13/04

(21) Application number: **91116338.4**

(22) Date of filing: **25.09.1991**

(54) **Process for fabrication of magneto-optic recording medium**

Verfahren zur Herstellung von magnetooptischen Aufzeichnungsträgern

Procédé pour fabriquer un milieu d'enregistrement magnéto-optique

(84) Designated Contracting States:
**DE FR GB NL**

(30) Priority: **29.09.1990 KR 1567690**

(43) Date of publication of application:
**08.04.1992 Bulletin 1992/15**

(73) Proprietor: **LG ELECTRONICS INC.
Seoul (KR)**

(72) Inventors:
• **Shin, Sung Chul
Yusung-ku, Taejeon-si (KR)**
• **Kim, Jin Hong
Yusung-ku, Daejeon-si (KR)**

(74) Representative:
**Müller, Hans-Jürgen, Dipl.-Ing. et al
Patentanwälte Dipl.-Ing. Hans-Jürgen Müller,
Dipl.-Chem.Dr. Gerhard Schupfner,
Dipl.-Ing. Hans-Peter Gauger,
Postfach 101161
80085 München (DE)**

(56) References cited:
**EP-A- 0 304 873          WO-A-91/14263**

• **PATENT ABSTRACTS OF JAPAN, unexamined
applications, P field, vol. 12, no. 46, February 12,
1988 THE PATENT OFFICE JAPANESE
GOVERNMENT page 107 P 665**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

**Description**

Field of the invention

The present invention relates to a process for fabrication of a magneto-optic recording medium, and particularly to a thin multi-layer type magneto-optic recording medium including Co/Pd or Co/Pt layers.

Background of the invention

Generally, magneto-optic recording technique is constituted such that a thin film having a vertical magnetic polarity is magnetically oriented upwardly or downwardly, thereby making it possible to store binary digital information.

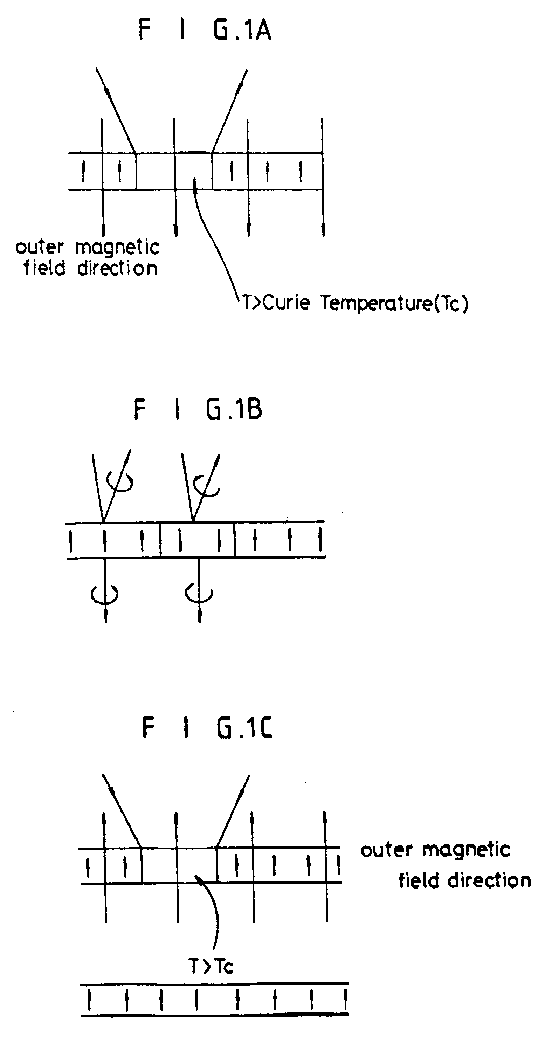

Such an information recording is carried out in such a manner that : as shown in Figure 1A, a magnetic field of about 300 Oe is applied in the desired direction from the external ; at the same time, the medium is heated by means of laser beams up to the curie temperature at which the medium loses its magnetic property : and then, the laser beams are withheld so as for the scanned regions of the medium to be magnetized in the same polarity as the external magnetic field, thereby recording the information.

As shown in Figure 1B, the reading of the recorded information is carried out by utilizing the Polar Kerr effect. That is, if rotational polarized light rays are scanned onto a vertically magnetized material, the reflected light rays are rotated around the polarizing direction of the incoming light rays. The magnitude of the rotational angle depends on the magnitude of magnetization, and the rotational direction is formed clockwise or the anticlockwise in accordance with the amgnetized direction. Therefore, the reflecting light rays which are reflected from the upwardly and downwardly magnetized spots are detected, thereby reading the information.

Meanwhile, as shown in Figure 1C, the erasing of a recorded information is carried out in such a manner that : the external magnetic field is applied in a direction opposite to that of the recording magnetic field. Such recording, erasing and re-recording can be repeated infitely by reversing the applied magnetic field.

In the currently used magneto-optic recording medium, a thin layer consisting of rare earth-transition metal alloy is employed, and the rare earth elements include Tb, Cd, Nd, Dy, while the transition metals include Fe, Co, and the like. Among them, the most superior recording medium is made of Tb-Fe-Co. Meanwhile, in manufacturing the rare-earth-transition metal alloy recording film, principally, sputtering and vacuum depositing method are used. In the case of the sputtering, an alloy target is employed, or a Co-sputtering in which the rare earth and the transition metal serve as plural targets respectively is adopted.

In the rare earth-transitional metal alloy recording medium, oxidation happens very easily, because the rare earths have a close affinity to oxygen. Therefore, in order to prevent such a phenomenon, and to increase the rotational angle during a reading, dielectric media are formed on the opposite faces of the recording film as protecting layers. The materials for the protecting layer may be cited to be Si3N4, A1N and other nitrides.

However, in the above described conventional technique, the rare earth-transitional metal alloy recording medium is liable to be oxidized due to the fact that the rare earths have gaeat affinity with oxygen. Although dielectric layers are employed in order to prevent the oxidizing phenomenon, the protecting function is not sufficient.

Futher, the recording medium is sensitively affected by the manufacturing process, and the yield is only about 10%. In order to overcome the above described problems, a treaties " Megnetic-optical properties of Co/Pd superlating thin film " has been published in the Journal of Applied Physics, volume 67, Page 317 (1990).

According to the technique as published in it, the magneto-optic recording medium includes a multi layer film of Co/Pd, and the thickness of the Co sub-layer is 1Å, while the thickness of the Pd sub layer is 6 - 15Å, with such layers being stacked repeatedly until the total thickness of the recording medium becomes 110 - 270Å.

The manufacturing method for the multi-layer thin film is constituted such that : a vacuum chamber accommodates a rotary table having a plurality of partitions on it, with the partitions being formed by means of stainless steel plates ; a base plate is mounted upon the rotary table ; and plurality a of crucibles containing Co and Pd respectively are disposed below the rotary table.

In such an apparatus, the Co and Pd of the crucibles are deposited onto the upper base plate by applying the thermal evaporation deposition method, and then, a second deposition is carried out by rotating the rotary table, in such a manner that Pd should be deposited on the Co, and that Co should be deposited on the Pd. Such depositions are repeated to form a multi-layer film of Co/Pd.

However, in such a manufacturing method, the number of the stainless steel partitions is limited, and therefore, a continuous production becomes difficult. Further, the thermal deposition method makes it unsuitable to the high melting point materials such as Pt, as well as making it difficult to obtain a uniform deposition.

Summary of the invention

It is the object of the present invention to provide a process and an apparatus for fabrication of a magnetic-optic recording medium, in accordance with the appended Claims.

Brief description of the drawings

The above object and other advantages of the present invention will become more apparent by describing in detail the preferred embodiment of the present invention with refernce to the attached drawings in which :

Figure 1A illustrates recording of information ;
Figure 1B illustrates reading of information ;
Figure 1C illustrates erasing of information ; and
Figure 2 illustrates the structure of the target on which Co/PD or Co/Pt are deposited.

Description of the preferred embodiment

The process for fabrication of a magneto-optic recording medium according to the present invention is constituted such that :

Co and Pd or Co and Pt are arranged in the cited order ;
the elements are isolated by means of isolating plates ;
a target is let to perform reciprocal horizontal movements over the element arrangement ; and a sputtering method is applied in such a manner as to deposit the Co and Pd or the Co and Pt onto the base plate.

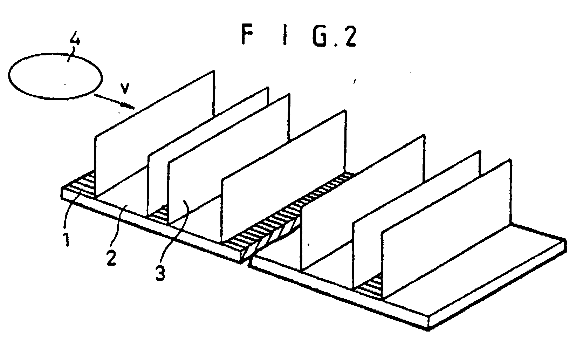

Referring to Figure 2, Co 1 and Pd 2 or Pt are arranged in the cited order in plural numbers within a vacuum chamber, thereby forming a target. Isolating plates 3 are installed between the Co 1 and the Pd 2 or Pt which are disposed on the target.

A base plate 4 is installed over the isolating plates 3.

In this state, if a voltage is supplied to the target, then argon gases are accelerated toward the charged target to be collided with the target, and materials are emitted from the target to be deposited onto the base plate 4. Under this condition, the base plate moves continuously to the right, and therefore, first the Co 1 is deposited. Then, if the base plate 4 passes the Co region, and if it arrives at the Pd region, then the Pd 2 is deposited upon the Co layer. This process is repeated, with the result that a muti -layer film consisting of repetitions of Co/Pd or Co/Pt is formed. That is, the base plate passes continuously over the arrangement of Co and Pd regions, and therefore, a multi-layer film can be obtained. The function of the isolating plates 3 is to prevent the simultaneous adherences of the Co, and Pd.

The arrangement of the Co 1 and the Pd 2 or Pt can be constituted in accordance with the required number of the sub-layers. Further, the base plate 4 can be moved to the left and right in performing the depositions, and therefore, the arrangement of the Co 1 and the Pd 2 does not have to be too long.

The width d of the Co or Pd regions between the isolating plates 3 is decided proportionately to

$$d - \frac{V}{R} \,,$$

assuming that the sputtering rate is decided in relation with the velocity V of the base plate 4 and the power supplied to the target. Thus the width d can be decided based on the above formula. If $V \simeq 1$ cm/s , and R = Å/ s , then

$$d - \frac{V}{R} - 1 \text{cm/Å}.$$

Accordingly, if the required thickness of Co is 1 Å, then d is 1 cm.

According to the present invention as described above, the Co 1 and the Pd 2 or Pt are continuously arranged on a single target, with the isolating plates being installed between the elements. Therefore, a multilayer thin film consisting of Co and Pd or Pt sub-layers can be formed by horizontally moving the base plate, with the result that the fabricating time is short, and that the process becomes simple.

**Claims**

1. A method for producing a magneto-optical recording medium with a recording layer consisting of alternately stacked Co and Pd or Co and Pt layers within a multi layered structure by

arranging at least one region (1) consisting essentially of cobalt and at least one region (2) consisting essentially of palladium or platinum in substantially alternating areas on a single target,
applying a voltage to said targets to induce sputtering of said cobalt, palladium and/or platinum from said targets, positioning a substrate (4) towards those targets and subjecting said substrate (4) to said sputtering so that said layers are alternately deposited on said substrate (4),

characterized in that
said substrate being repeatedly reciprocated between a position above a cobalt region and a position above a region of platinum or palladium linearly arranged one behind the other, and isolating each region (1) of cobalt from each adjacent region (2) of palladium or platinum by means of vertical steel plates.

2. The method of claim 1,
**characterized in that**
said vertical plates (3) retard depositing a mixture of cobalt and platinum or a mixture of cobalt and palladium on said substrate (4).

3. The method of claims 1 or 2,
**characterized in that**
said method is conducted at a pressure less than atmospheric pressure in a gaseous atmosphere consisting essentially of argon.

4. Apparatus for carrying out the method according to one of the preceding claims, comprising a single target which comprises at least one region (1) of cobalt and at least one other region (2) of palladium or platinum to be sputtered on a substrate (4) movable with regard to said targets,

**characterized in that** said regions (1,2) are separated by an isolating steel plate (3) extending from said single target towards said substrate (4) being moved repeatedly reciprocated with regard to said target.

## Patentansprüche

1. Verfahren zur Herstellung eines magnetooptischen Aufzeichnungsmediums mit einer Aufzeichnungsschicht, die aus abwechselnd gestapelten Co- und Pd- oder Co- und Pt-Schichten innerhalb einer Mehrschichtstruktur bestehen,

   wobei in im wesentlichen abwechselnden Bereichen auf einem einzigen Target wenigstens ein Bereich (1), der im wesentlichen aus Kobalt besteht, und wenigstens ein Bereich (2) angeordnet wird, der im wesentlichen aus Palladium oder Platin besteht,
   wobei eine Spannung an die Targets angelegt wird, um das Sputtern des Kobalts, Palladiums und/oder Platins von den Targets zu induzieren, wobei ein Substrat (4) an diesen Targets positioniert und derart dem Sputtern unterzogen wird, daß abwechselnd Schichten auf das Substrat (4) aufgebracht werden,

   **dadurch gekennzeichnet, daß**
   das Substrat wiederholt zwischen einer Position über einem Kobalt-Bereich und einer Position über einem Bereich aus Platin oder Palladium hin- und herbewegt wird, die linear hintereinander angeordnet sind, und jeder Kobalt-Bereich (1) mittels vertikaler Stahlplatten von jedem angrenzenden Bereich (2) aus Palladium oder Platin isoliert ist.

2. Verfahren nach Anspruch 1,
   **dadurch gekennzeichnet, daß**
   die vertikalen Platten (3) die Abscheidung eines Gemisches aus Kobalt und Platin oder eines Gemisches aus Kobalt und Palladium auf diesem Substrat (4) verzögern.

3. Verfahren nach Anspruch 1 oder 2,
   **dadurch gekennzeichnet, daß**
   das Verfahren bei einem niedrigeren Druck als Atmosphärendruck in einer gasförmigen Atmosphäre durchgeführt wird, die im wesentlichen aus Argon besteht.

4. Vorrichtung zur Durchführung des Verfahrens nach einem der vorhergehden Ansprüche, mit einem einzigen Target, das wenigstens einen Bereich (1) aus Kobalt und wenigstens einen weiteren Bereich (2) aus Palladium oder Platin aufweist, die auf ein Substrat (4) gesputtert werden sollen, das bezüglich der Targets bewegbar ist,

   **dadurch gekennzeichnet, daß**
   die Bereiche (1, 2) durch eine isolierende Stahlplatte (3) voneinander getrennt sind, die sich von dem einzigen Target zu dem Substrat (4) erstreckt, das wiederholt bezüglich des Targets hin- und herbewegt wird.

## Revendications

1. Procédé pour fabriquer un milieu d'enregistrement magnéto-optique ayant une couche d'enregistrement comprenant un empilage alterné de couches de Co et de Pd ou de Co et de Pt dans une structure multicouche comprenant :

   prévoir au moins une région (1) comprenant essentiellement du cobalt et au moins une région (2) comprenant essentiellement du palladium ou du platine dans des régions sensiblement alternées sur une même cible,
   appliquer une tension sur lesdites cibles pour créer une pulvérisation desdits cobalt, palladium et/ou platine à partir desdites cibles,
   placer un substrat (4) en direction des cibles et soumettre ledit substrat (4) à ladite pulvérisation, de façon à déposer des couches alternées sur ledit substrat (4),

   caractérisé en ce que ledit substrat subit un mouvement alternatif répété entre une position située au-dessus d'une région de cobalt et une position située au-dessus d'une région de platine ou de palladium qui sont linéairement disposées l'une après l'autre,
   et isoler chaque région (1) de cobalt de chaque région adjacente (2) de palladium ou de platine au moyen de plaques d'acier verticales.

2. Procédé selon la revendication 1,
   caractérisé en ce que lesdites plaques verticales (3) retardent le dépôt d'un mélange de cobalt et de platine ou d'un mélange de cobalt et de palladium sur ledit substrat (4).

3. Procédé selon l'une des revendication 1 ou 2,
   caractérisé en ce que
   ledit procédé est appliqué sous une pression inférieure à la pression atmosphérique dans une atmosphère gazeuse contenant essentiellement de l'argon

**EP 0 479 109 B1**

4. Appareil pour appliquer le procédé selon l'une des revendications précédentes, comprenant une seule cible qui comprend au moins une région (1) de cobalt et au moins une autre région (2) de palladium ou de platine à pulvériser sur un substrat (4) mobile par rapport auxdites cibles,

caractérisé en ce que

lesdites régions (1, 2) sont séparées par une plaque isolante en acier (3) s'étendant de ladite première cible vers ledit substrat (4) qui est déplacé alternativement de manière répétitive par rapport à ladite cible.

# F I G.1A

outer magnetic
field direction

T>Curie Temperature(Tc)

# F I G.1B

# F I G.1C

outer magnetic

field direction

T>Tc

# F I G.2